# EUROPEAN PATENT APPLICATION

(11) **EP 4 318 560 A1**
(43) Date of publication of application: **07.02.2024**
(21) Application number: 23177564.4
(22) Date of filing: 06.06.2023
(51) Int. Cl.: H01L 21/822, H01L 21/8238, H01L 27/06, H01L 27/092, H01L 29/06, H01L 29/66, H01L 29/775, H01L 29/786

(54) **3DSFET STANDARD CELL ARCHITECTURE WITH SOURCE-DRAIN JUNCTION ISOLATION**

(30) Priority: 05.08.2022 US 202263395596 P; 05.08.2022 US 202263395604 P; 09.11.2022 US 202217984042
(71) Applicant: Samsung Electronics Co., Ltd., Suwon-si, Gyeonggi-do 16677 (KR)
(72) Inventor: HE, Ming, San Jose, CA, 95134 (US); SAREMI, Mehdi, San Jose, CA, 95134 (US); PARK, Rebecca, San Jose, CA, 95134 (US); AHOSAN UL KARIM, Muhammed, San Jose, CA, 95134 (US); SIMKA, Harsono, San Jose, CA, 95134 (US); PARK, Sungil, San Jose, CA, 95134 (US); KANG, Myungil, San Jose, CA, 95134 (US); KIM, Kyungho, San Jose, CA, 95134 (US); CHOI, Doyoung, San Jose, CA, 95134 (US); PARK, JaeHyun, San Jose, CA, 95134 (US)
(74) Representative: Kuhnen & Wacker Patent- und Rechtsanwaltsbüro PartG mbB

(57) **Abstract**

Provided is a three-dimensionally stacked field-effect transistor (3DSFET) device (500) which includes: a 1^{st} lower source/drain region (512L) and a 2^{nd} lower source/drain region (512R) connected to each other through a 1^{st} lower channel structure (510) controlled by a 1^{st} gate structure (515); and a 1^{st} upper source/drain region (522L) and a 2^{nd} upper source/drain region (522R), respectively above the 1^{st} lower source/drain region and the 2^{nd} lower source/drain region, and connected to each other through a 1^{st} upper channel structure (520) controlled by the 1^{st} gate structure (515), wherein the 2^{nd} lower source/drain region and the 2^{nd} upper source/drain region form a PN junction therebetween.

## Description

### BACKGROUND

### 1. Field

Apparatuses and methods according to embodiments relate to a cell architecture of a three-dimensionally (3D) stacked field-effect transistor device including a PN junction structure.

### 2. Description of the Related Art

Growing demand for integrated circuits having high device density as well as high performance has introduced a 3D stacked field-effect transistor (3DSFET) device in which two or more field-effect transistors such as fin field-effect transistor (FinFET) and nanosheet transistor are vertically stacked. The FinFET has one or more horizontally arranged vertical fin structures as a channel structure of which at least three surfaces are surrounded by a gate structure, and the nanosheet transistor is characterized by one or more nanosheet channel layers vertically stacked on a substrate as a channel structure and a gate structure surrounding all four surfaces of each of the nanosheet channel layers. The nanosheet transistor is referred to as gate-all-around (GAA) transistor, multi-bridge channel field-effect transistor (MBCFET).

However, the 3DSFET device is also known to be difficult to manufacture due to the high device density requiring high aspect-ratio patterning and isolation. For example, as a 3DSFET forming the 3DSFET device has two or more vertically-stacked field-effect transistors, a lower field-effect transistor at a lower stack is vertically overlapped by an upper field-effect transistor at an upper stack. Thus, a middle-of-line (MOL) structure, e.g., a source/drain region contact plug, connecting a back-end-of-line (BEOL) structure such as a power metal line to a source/drain region of the lower field-effect transistor may have to be formed outside the 3DSFET and/or bent to be connected a side surface of the source/drain region of the lower field-effect transistor. However, this connection structure for the 3DSFET increases an overall footprint the 3DSFET. Thus, a 3DSFET having different channel widths between a lower field-effect transistor and an upper field-effect transistor has been introduced to address the above problem.

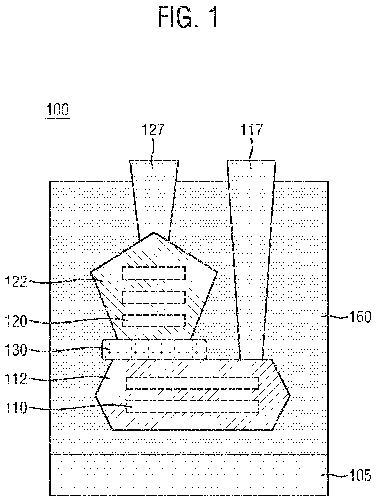

FIG. 1 illustrates a structure of a 3DSFET having different channel widths between a lower field-effect transistor and an upper field-effect transistor formed thereabove.

Referring to FIG. 1, a 3DSFET 100 formed on a substrate 105 includes a lower source/drain region 112 and an upper source/drain region 122 respectively formed on a lower channel structure 110 and an upper channel structure 120. Since FIG. 1 is a channel-width direction view of the 3DSFET taking a cross section at source/drain regions, other structural elements of the 3DSFET100 including a gate structure surrounding the channel structures 110 and 120 are not shown.

The 3DSFET 100 further includes a dielectric layer 130 formed between the lower source/drain region 112 and the upper source/drain region 122 to isolate the source/drain regions 112 and 122 from each other. Further, A lower source/drain contact plug 117 and an upper source/drain contact plug 127 are formed on the lower source/drain region 110 and the upper source/drain region 120, respectively, to receive respective voltage input signals or output respective output signals or routing signals.

In this 3DSFET, a width of the upper channel structure 120 is configured to be smaller than that of the lower channel structure 110 so that the upper source/drain region 122 grown from the upper channel structure 120 also has a small width than the lower source/drain region 112 grown from the lower channel structure 110. Thus, a lower source/drain contact plug 117 as an MOL structure may be connected to the lower source/drain region through a space provided at a region where the lower field-effect transistor is not vertically overlapped by the upper field-effect transistor.

However, because of a high-aspect ratio of the lower source/drain contact plug 117 patterned in an interlayer dielectric layer (ILD) structure 160, there still remain manufacturing difficulties and contact resistance issues in addition to a complicated process of forming different channel-width field-effect transistors. Further, a nanoscale distance between the lower source/drain contact plug 117 and the upper source/drain region 122 exposes a short-circuit risk.

Further when the source/drain regions 112 and 122 are formed, a lower epitaxial structure (Epi) for the lower source/drain region 112 may be grown first from the substrate 105 and/or the lower channel structure 110, and the dielectric layer 130 for the electrical isolation may be formed thereon. Further, this dielectric layer 130 needs to be etched back to provide a space for growing an upper Epi for the upper source/drain region 122 in the etched-back space based on the upper channel structure 120.

However, the formation of the dielectric layer 130 including the etch-back operation may expose various challenges in manufacturing the 3DSFET device 100. For example, if the dielectric layer 130 is etched back too deep, the lower source/drain region 112 may form a short circuit with the upper source/drain region 122. On the contrary, if the dielectric layer 130 is etched back insufficiently, it may prevent the upper Epi from properly being grown in the etched-back space to form the upper source/drain region.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a 3DSFET device in which a PN junction structure is formed to electrical isolate a lower source/drain region and an upper source/drain region, according to embodiments.

According to an embodiment, there is provided a 3DSFET device which may include: a 1^{st} lower source/drain region and a 2^{nd} lower source/drain region connected to each other through a 1^{st} lower channel structure controlled by a 1^{st} gate structure; and a 1^{st} upper source/drain region and a 2^{nd} upper source/drain regions, respectively above the 1^{st} lower source/drain region and the 2^{nd} lower source/drain region, and connected to each other through a 1^{st} upper channel structure controlled by the 1^{st} gate structure, wherein the 2^{nd} lower source/drain region and the 2^{nd} upper source/drain region form a PN junction therebetween.

According to an embodiment, there is provided a 3DSFET device which may include: a 1^{st} lower source/drain region and a 2^{nd} lower source/drain region connected to each other through a 1^{st} lower channel structure controlled by a 1^{st} gate structure; and a 1^{st} upper source/drain region and a 2^{nd} upper source/drain regions, respectively above the 1^{st} lower source/drain region and the 2^{nd} lower source/drain region, and connected to each other through a 1^{st} upper channel structure controlled by the 1^{st} gate structure; and a 1^{st} PN junction structure in a reverse-biased form between the 1^{st} lower source/drain region and the 1^{st} upper source/drain region, wherein the 1^{st} lower source/drain region is either connected to a 1^{st} voltage source or configured to pass a 2^{nd} signal from a 3^{rd} lower source/drain region connected to the 1^{st} lower source/drain region through a 2^{nd} lower channel structure to the 2^{nd} lower source/drain region, the 3^{rd} lower source/drain region being at a side opposite to the 2^{nd} lower channel structure with respect to the 1^{st} lower source/drain region, and wherein the 1^{st} upper source/drain region is connected to a 2^{nd} voltage source of a polarity opposite to the 1^{st} voltage source.

According to an embodiment, there is provided a 3DSFET device which may include: a 1^{st} lower source/drain region and a 2^{nd} lower source/drain region connected to each other through a 1^{st} lower channel structure controlled by a 1^{st} gate structure; and a 1^{st} upper source/drain region and a 2^{nd} upper source/drain regions, respectively above the 1^{st} lower source/drain region and the 2^{nd} lower source/drain region, and connected to each other through a 1^{st} upper channel structure controlled by the 1^{st} gate structure; and a 1^{st} PN junction structure in a reverse-biased form between the 1^{st} lower source/drain region and the 1^{st} upper source/drain region, configured to electrically isolate the 1^{st} upper source/drain region from the 1^{st} lower source/drain region, wherein an upper portion of the 1^{st} PN junction structure is above the upper source/drain region, and an upper portion of the 1^{st} lower source/drain region is above the upper portion of the 1^{st} PN junction structure, wherein the 1^{st} lower source/drain region is configured to receive a 1^{st} signal from the 2^{nd} lower source/drain region, and output the 1^{st} signal through the upper portion thereof, and wherein the 1^{st} upper source/drain region is configured to pass a 2^{nd} signal received from the 2^{nd} upper source/drain region to another circuit element, or float when the 2^{nd} signal is received from the 2^{nd} upper source/drain region

### BRIEF DESCRIPTION OF DRAWINGS

Example embodiments of the inventive concept will be more clearly understood from the following detailed description taken in conjunction with the accompanying drawings in which:
FIG. 1 illustrates a structure of a 3DSFET having different channel widths between a lower field-effect transistor and an upper field-effect transistor formed thereabove;
FIG. 2A illustrates a schematic of a PN structure which may be used as a lower source/drain region and an upper source/drain region of a 3DSFET, according to an embodiment, and FIG. 2B is a post-simulation diagram showing formation of the PN structure in an intermediate 3DSFET structure, according to an embodiment;
FIG. 3A is a schematic of a PNPN structure which is used as a lower source/drain region and an upper source/drain region of a 3DSFET, and FIG. 3B is a post-simulation diagram showing formation of the PNPN structure based on a substrate and channel structures of an intermediate 3DSFET structure;
FIG. 4A is a schematic of a P(NPN) structure which is used as a lower source/drain region and an upper source/drain region of a 3DSFET, and FIG. 4B is a post-simulation diagram showing formation of the P(NPN) structure based on a substrate and channel structures of an intermediate 3DSFET structure;
FIG. 5A illustrates a circuit schematic of a one (1) active contacted poly (gate) pitch (1-CPP) inverter, and FIG. 5B illustrates a simplified cell architecture for the 1-CPP inverter implemented by a 3DSFET device, according to an embodiment;
FIG. 6A illustrates a circuit schematic of a 2-CPP inverter, which is a buffer circuit, and FIG. 6B illustrates a simplified standard cell architecture for the buffer circuit implemented by a 3DSFET device, according to an embodiment;
FIG. 7A illustrates a circuit schematic of a 2-CPP cross-couple circuit, and FIG. 7B illustrates a simplified standard cell architecture for the cross-couple circuit implemented by a 3DSFET device, according to an embodiment;
FIG. 8A illustrates a circuit schematic of a 2-CPP NAND2 circuit, and FIG. 8B illustrates a simplified standard cell architecture for the NAND2 circuit implemented by a 3DSFET device, according to an embodiment;
FIG. 9A illustrates a circuit schematic of a 3-CPP AND2 circuit, and FIG. 9B illustrates a simplified standard cell architecture for the AND2 circuit implemented by a 3DSFET device, according to an embodiment;
FIG. 10A illustrates a circuit schematic of a 2-CPP NOR2 circuit, and FIG. 10B illustrates a simplified standard cell architecture for the NOR2 circuit implemented by a 3DSFET device, according to an embodiment; and
FIG. 11 is a schematic block diagram illustrating an electronic device including at least one 3DSFET device including one or more of a PN structure, a PNPN structure and a P(NPN) structure for a lower source/drain region and an upper source/drain region, according to an embodiment.

### DETAILED DESCRIPTION OF EXAMPLE EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers and sacrificial layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be understood that, although the terms 1^{st}, 2^{nd}, 3^{rd}, 4^{th}, etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices such as a FinFET and a nanosheet transistor may or may not be described in detail herein. For example, a certain isolation layer or structure of a semiconductor device may be omitted herein when this layer or structure is not related to the various of aspects of the embodiments.

Herebelow, various embodiments are presented to address the problems of the source/drain regions described in the Background section.

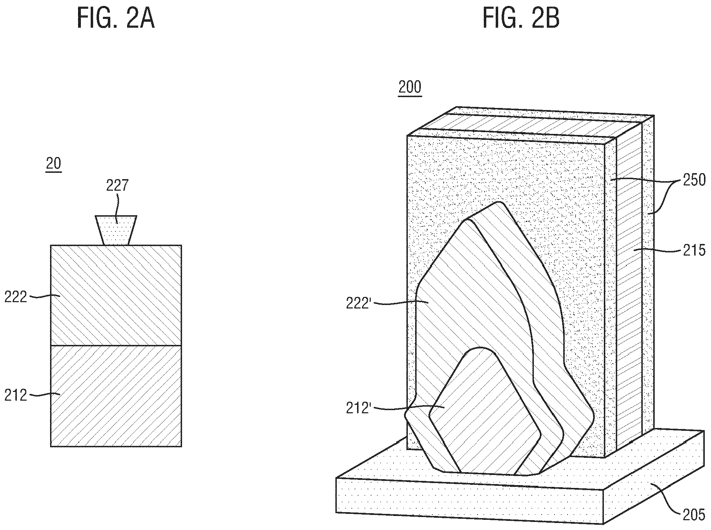

FIG. 2A illustrates a schematic of a PN structure which may be used as a lower source/drain region and an upper source/drain region of a 3DSFET, according to an embodiment, and FIG. 2B is a post-simulation diagram showing formation of the PN structure in an intermediate 3DSFET structure, according to an embodiment.

FIG. 2A is a cross-section view of a PN structure 20 in a channel-length direction, and FIG. 2B is a perspective view, including a channel-width direction view, of an intermediate 3DSFET structure 200 including the PN structure 20 before the intermediate 3DSFET structure 200 is finished as a 3DSFET.

Referring to FIG. 2A, the PN structure 20 may include a lower source/drain region 212 and an upper source/drain region 222. Further, the PN junction structure 20 may be provided with an upper source/drain contact plug 227 on a top surface of the upper source/drain region 222.

Each of the lower source/drain region 212 and the upper source/drain region 222 may include silicon (Si) and/or silicon germanium (SiGe), not being limited thereto. For example, the lower source/drain region 212 may include SiGe, and the upper source/drain region 222 may include Si. Further, the lower source/drain region 212 may include p-type dopants such as boron (B), gallium (Ga), etc. and the upper source/drain region 222 may include n-type dopants such as phosphorus (P), arsenic (As), antimony (Sb), etc. Thus, the lower source/drain region 212 may be of p-type which can be used a source/drain region of a lower metal-oxide-semiconductor field-effect transistor (PMOS), that is, a lower source/drain region of a 3DSFET device, and the upper source/drain region 222 may be of n-type which can used a source/drain region of an upper source/drain region for an upper metal-oxide-semiconductor field-effect transistor (NMOS), that is, an upper source/drain region of the same 3DSFET device.

The upper source/drain contact plug 227 may be formed of a metal such as copper (Cu), tungsten (W), molybdenum (Mo), ruthenium (Ru), etc., or a compound thereof.

According to the characteristics of a PN junction, when the PN structure 20 is in a forward-bias condition, that is, when a positive voltage signal from a positive voltage input signal (Vdd) is received at the lower source/drain region 212 of p-type in the 3DSFET device, the Vdd signal may be transferred to the upper source/drain region 222 of n-type, and output through the upper source/drain contact plug 227. Further, when a negative voltage signal from a negative voltage source (Vss) is received at the upper source/drain region 222 of n-type in the 3DSFET device, the Vss signal may be transferred out to the output node through the upper source/drain contact plug 227. Here, not only the Vss signal received at the 2^{nd} upper source/drain region 222 but also the Vdd signal received at the lower source/drain region 212 may be output from the upper source/drain region 222 through the upper source/drain contact plug 227 to the output node. Thus, the upper source/drain region 222 and the upper source/drain contact plug 227 form a common output structure which may be able to output any one of the Vdd signal and the Vss signal to an output node.

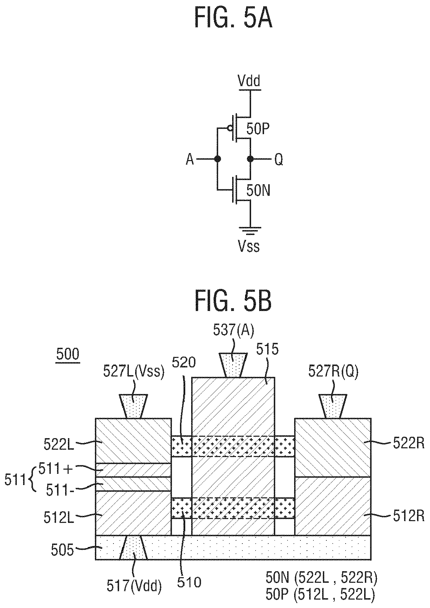

According to an embodiment, the PN structure 20 may form a lower source/drain region and an upper source/drain region of a 3DSFET for a complimentary metal-oxide-semiconductor (CMOS) device such as an inverter circuit which outputs either of the Vdd signal and the Vss signal when the CMOS device is activated. For example, as will be described later in reference to FIGS. 5A-5B to 10A-10B, the lower source/drain region 212 of p-type and the upper source/drain region 222 of n-type may respectively form a lower source/drain region for a PMOS and an upper source/drain region for an NMOS so that the PMOS and the NMOS can form a CMOS device in a 3DSFET device. In this case, the PN structure 20 along with a single output contact plug, that is, the upper source/drain contact plug 227 on the top surface of the PN structure 20, may be used as a common output structure of the CMOS device.

Thus, when the lower source/drain region 212 and the upper source/drain region 222 of the PN structure 20 form a part of a CMOS device in a 3DSFET device, a lower source/drain contact plug like the lower source/drain contact plug 117 of the 3DSFET device 100 shown in FIG. 1 may not be required, and only the upper source/drain contact plug 227 may be formed on the top surface of the PN structure 20. In addition, a dielectric layer isolating the two source/drain regions like the dielectric layer 130 of the 3DSFET 100 may not be required when the PN structure 20 is used as the common output structure of a 3DSFET device. Thus, the PN structure 20 may enable improvement of device density and performance as well as manufacturing simplicity for the 3DSFET device.

When the upper source/drain contact plug 227 is formed on the top surface of the upper source/drain region 222 which faces a BEOL of the 3DSFET, formation of the upper source/drain contact plug 227 may be easier than if it is formed at other portions of the PN structure 20. However, the disclosure is not limited thereto, and a backside contact plug instead of the upper source/drain contact plug 227 may be formed on a bottom surface of the lower source/drain region 212 through a backside power distribution network (BSPDN) subject to design choice, according to an embodiment.

Referring to FIG. 2B, formation of the PN structure 20 may begin with sealing an upper region of the intermediate 3DSFET structure 200 and epitaxially growing a lower epitaxial layer (Epi) 212' based on a substrate 205 and a lower channel structure (not shown) surrounded by a dummy gate structure 215. Next, the sealed upper region of the intermediate 3DSFET structure 200 may be opened, and an upper Epi 222' may be epitaxially grown based on the lower Epi 212' and an upper channel structure (not shown) surrounded by the dummy gate structure 215. The lower Epi 212' and the upper Epi 222' may eventually form the lower source/drain region 212 and the upper source/drain region 222, respectively, shown in FIG. 2A.

The substrate 205 may be an Si substrate although it may include other materials such as SiGe, silicon carbide (e.g., SiC), not being limited thereto. The channel structures may include Si or SiGe that may have been epitaxially grown based on the substrate 205.

According to an embodiment, the upper Epi 222' may be grown based on not only the upper channel structure but the lower Epi 212' which is earlier grown. Thus, at least for this reason, the upper Epi 222' may take a form of surrounding the lower Epi 212' except a bottom surface thereof above the substrate 205, as shown in FIG. 2B.

The lower Epi 212' may be formed of SiGe, and the upper Epi 222' may be formed of Si, for example, not being limited thereto. When the lower Epi 212' and the upper Epi 222' are respectively grown, p-type dopants and n-type dopants may be doped, implanted or diffused in the lower Epi 212' and the upper Epi 222', respectively, to finish the lower Epi 212' and the upper Epi 222' as the p-type lower source/drain region 212 and the n-type upper source/drain region 222, respectively. The dummy gate structure 215 may be replaced by a replacement metal gate structure later in a step of manufacturing a 3DSFET device including the PN structure 20.

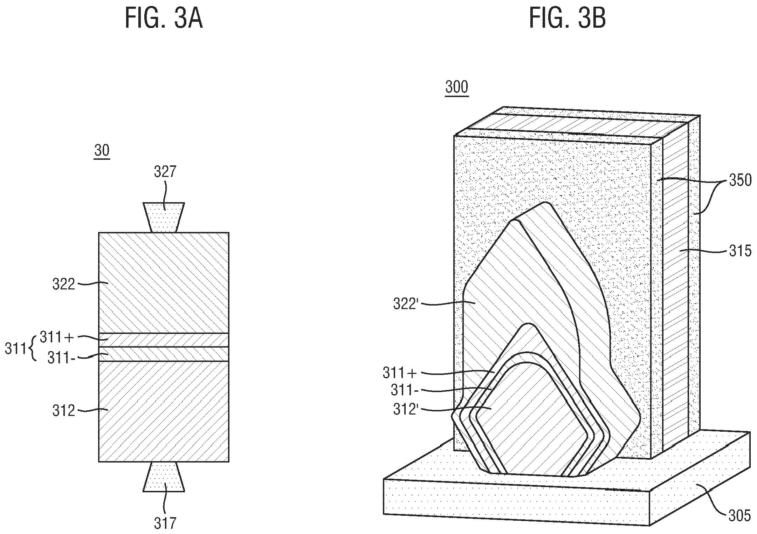

FIG. 3A is a schematic of a PNPN structure which is used as a lower source/drain region and an upper source/drain region of a 3DSFET, and FIG. 3B is a post-simulation diagram showing formation of the PNPN structure based on a substrate and channel structures of an intermediate 3DSFET structure.

FIG. 3A is a cross-section view of a PNPN structure 30 in a channel-length direction, and FIG. 3B is a perspective view, including a channel-width direction view, of an intermediate 3DSFET structure 300 including the PNPN structure 30 before the intermediate 3DSFET structure 300 is finished as a 3DSFET device.

Referring to FIG. 3A, the PNPN structure 30 may include a lower source/drain region 312 of p-type and an upper source/drain region 322 of n-type with a PN junction structure 311 therebetween. The PN junction structure 311 may include a 1^{st} semiconductor layer and a 2^{nd} semiconductor layer, which respectively form an n-type region 311- and a p-type region 311 + of the PN junction structure 311.

The lower source/drain region 312 of p-type and the upper source/drain region 322 of n-type may include the same materials including respective dopants as the lower source/drain region 212 and the upper source/drain region 222 shown in FIG. 2A. Thus, duplicate descriptions thereof are omitted herein.

Each of the 1^{st} semiconductor layer and the 2^{nd} semiconductor layer of the PN junction structure 311 may be formed of Si, not being limited thereto. Further, the 1^{st} semiconductor layer may include n-type dopants similar to those included in the n-type upper source/drain region 322, and the 2^{nd} semiconductor layer may include p-type dopants similar to those included in the p-type lower source/drain region 312. Thus, the 1^{st} semiconductor layer may form the n-type region 311- of the PN junction structure 311, and the 2^{nd} semiconductor layer may form the p-type region 311 + of the PN junction structure 311.

The PNPN structure 30 may be provided with a lower source/drain contact plug 317 on a bottom surface of the lower source/drain region 312 and an upper source/drain contact plug 327 on a top surface of the upper source/drain region 322. The lower source/drain contact plug 317 may be a backside contact plug included in a BSPDN. As will be described later, the lower source/drain contact plug 317 may not be formed on the lower source/drain region 312 in a 3DSFET device including the PNPN structure 30. The contact plugs 317 and 327 each may be formed of a material similar to that included in the upper source/drain contact plug 227 of the PN structure 20 in FIG. 2A.

According to an embodiment, the PN junction structure 311 including the n-type region 311- and the p-type region 311 + may be formed between the lower source/drain region 312 of p-type and the upper source/drain region 322 of n-type in a reverse-biased form. For example, the n-type region 311- may be formed on a top surface the lower source/drain region 312 of p-type, and the p-type region 311+ above the n-type region 311- may be formed on a bottom surface of the upper source/drain region 322 of n-type.

The PN junction structure 311 in the reversed-bias form may electrically isolate the lower source/drain region 312 from the upper source/drain region 322. For example, when the p-type lower source/drain region 312 and the n-type upper source/drain region 322 are respectively connected to Vdd and Vss through the lower source/drain contact plug 317 and the upper source/drain contact plug 327, the PN junction structure 311 may enter in a reverse-biased condition to prevent or minimize current flow between the lower source/drain region 312 and the upper source/drain region 322. In other words, the reverse-biased PN junction structure 311 may function as an electrical isolation structure between the lower source/drain region 312 and the upper source/drain region 322 in a reverse-biased condition.

Further, when the PN junction structure 311 is in the reverse-biased condition, the lower source/drain region 312 or the upper source/drain region 322 may pass (or relay) a signal received from one circuit element to another circuit element without transferring the signal to the upper source/drain region 322 or the lower source/drain region 312, respectively, or may float only to trap the signal thereinside. This is because the lower source/drain region 312 and the upper source/drain region 322 are electrically isolated from each other by the PN junction structure 311. For example, in a 3DSFET device including a plurality of serially-connected lower source/drain regions including the lower source/drain region 312, a signal received from a left lower source/drain region may pass through the lower source/drain region 312 to a right lower source/drain region or may be trapped inside the lower source/drain region 312 depending on the activation status of a PMOS including the right lower source/drain region, without being transferred to the upper source/drain region 322. In this example, the lower source/drain contact plug 317 may not be required on the lower source/drain region 312 in the 3DSFET device.

Thus, when the PNPN structure 30 forms the lower source/drain region 312 and the upper source/drain region 322 as above, a dielectric layer isolating the two source/drain regions 312 and 322 from each other may not be required, thereby improving device density and performance as well as manufacturing simplicity.

Referring to FIG. 3B, formation of the PNPN structure 30 may begin with sealing an upper region of an intermediate 3DSFET structure 300 and growing a lower Epi 312' based on a substrate 305 and a lower channel structure (not shown) surrounded by a dummy gate structure 315. Next, the 1^{st} semiconductor layer (n-type region 311-) and the 2^{nd} semiconductor layer (p-type region 311+) may be sequentially grown in a similar epitaxy method based on the lower Epi 312'. Subsequently, the sealed upper region of the intermediate 3DSFET structure 300 may be opened, and an upper Epi 322' may be grown based on the 1^{st} and 2^{nd} semiconductor layers and an upper channel structure (not shown) surrounded by the dummy gate structure 315. The lower Epi 312', the 1^{st} and 2^{nd} semiconductor layer, and the upper Epi 322' may eventually form the lower source/drain region 312, the PN junction structure 311, and the upper source/drain region 322, respectively, shown in FIG. 3A.

The substrate 305 may be an Si substrate although it may include other materials such as SiGe, silicon carbide (e.g., SiC), not being limited thereto. The channel structures may include Si or SiGe that may have been epitaxially grown based on the substrate 305.

According to an embodiment, the 1^{st} and 2^{nd} semiconductor layers may be grown based on the lower Epi 312' which is earlier grown, and the upper Epi 322' may be grown based on not only the upper channel structure but the 1^{st} and 2^{nd} semiconductor layer. Thus, at least for this reason, the 1^{st} and 2^{nd} semiconductor layers and the upper Epi 322' may take a form of surrounding the lower Epi 312' except a bottom surface thereof above the substrate 305, as shown in FIG. 3B.

The lower Epi 312' may be formed of SiGe, and the upper Epi 322' may be formed of Si, for example, not being limited thereto. When the lower Epi 312' and the upper Epi 322' are respectively grown, p-type dopants and n-type dopants may be doped, implanted or diffused in the lower Epi 312' and the upper Epi 322', respectively, to finish the lower Epi 312' and the upper Epi 322' as the p-type lower source/drain region 312 and the n-type upper source/drain region 322, respectively, shown in FIG. 3A. Further, similar n-type dopants and p-type dopants may be doped, implanted or diffused in the 1^{st} and 2^{nd} semiconductor layers to finish these semiconductor layers as the n-type region 311- and the p-type region 311 + of the PN junction structure 311, respectively, shown in FIG. 3A.

The dummy gate structure 315 may be replaced by a replacement metal gate structure later in a step of manufacturing a 3DSFET device including the PNPN structure 30.

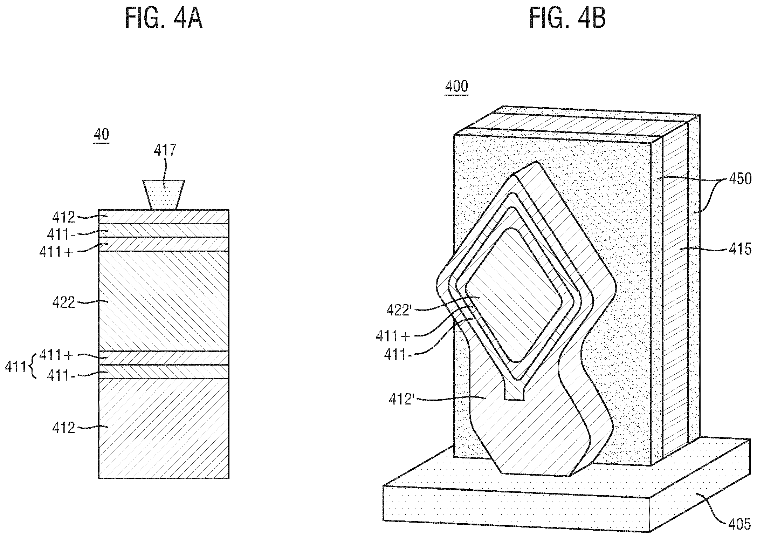

FIG. 4A is a schematic of a P(NPN) structure which is used as a lower source/drain region and an upper source/drain region of a 3DSFET, and FIG. 4B is a post-simulation diagram showing formation of the P(NPN) structure based on a substrate and channel structures of an intermediate 3DSFET structure.

FIG. 4A is a cross-section view of a P(NPN) structure 40 in a channel-length direction, and FIG. 4B is a perspective view, including a channel-width direction view, of an intermediate 3DSFET structure 400 including the P(NPN) structure 40 before the intermediate 3DSFET structure 400 is finished as a 3DSFET device.

Referring to FIG. 4A, a P(NPN) structure 40 may include a lower source/drain region 412 of p-type and an upper source/drain region 422 of n-type with a PN junction structure 411, therebetween. The PN junction structure 411 may include a 1^{st} semiconductor layer and a 2^{nd} semiconductor layer, which respectively form a p-type region 411+ and an n-type region 411-of the PN junction structure 411.

Further, in the P(NPN) structure 40, an upper portion of the PN junction structure 411 may be formed above the upper source/drain region 422, and an upper portion of the lower source/drain region 412 may be formed above the upper portion of the PN junction structure 411 above the upper source/drain region 422. As will be described later in reference to FIG. 4B which shows a channel-width direction cross-section of the PN junction structure 411, the upper portion of the PN junction structure 411 above the upper Epi 422 is connected to a lower portion of the PN junction structure 411 interposed between the two source/drain regions 412 and 422. Further, the upper portion of the lower source/drain region 412 above the PN junction structure 411 is connected to a lower portion of the lower source/drain region formed below the PN junction structure 411.

The lower source/drain region 412 of p-type and the upper source/drain region 422 of n-type may include the same materials including respective dopants as the lower source/drain region 312 and the upper source/drain region 322 shown in FIG. 3A. Further, the PN junction structure 411 including the 1^{st} semiconductor layer (p-type region 411+) and the 2^{nd} semiconductor layer (n-type region 411-) may include the same materials including respective dopants as the PN junction structure 311. Thus, duplicate descriptions thereof are omitted herein.

In the P(NPN) structure 40, a lower source/drain contact plug 417 may be formed on a top surface of the upper portion of the lower source/drain region 412 formed above the upper Epi 422. Thus, the lower source/drain region contact plug 417 may be connected to the lower source/drain region 412 without being bent to detour the overlapping upper source/drain region 422 in a 3DSFET device. The lower source/drain contact plug 417 may be formed of a material similar to that included in the contact plugs 317 and 327 of the PN structure 30 in FIG. 3A.

According to an embodiment, the PN junction structure 411 including the n-type region 411- and the p-type region 411 + may be formed between the lower source/drain region 412 of p-type and the upper source/drain region 422 of n-type in a reverse-biased form. For example, the upper source/drain region 422 of n-type may be surrounded by the p-type region 411+, which may surrounded by the n-type region 411-, which may be surrounded by the lower source/drain region 412 of p-type.

The PN junction structure 411 in the reversed-bias condition may electrically isolate the lower source/drain region 412 from the upper source/drain region 422. However, since the upper portion of the lower source/drain region 412 is extendedly formed above the upper source/drain region 422 with the PN junction structure 411 in the reverse-biased form therebetween as shown in FIGS. 4A and 4B, a voltage signal received at the lower source/drain region 412 may be transferred to the upper portion thereof above the upper source/drain region 422 without passing through the upper source/drain region 422, and output to an output node through the lower source/drain contact plug 417 formed on the upper portion of the lower source/drain region 412.

Further, when the PN junction structure 411 is in the reverse-biased condition, the lower source/drain region 412 or the upper source/drain region 422 may pass (or relay) a signal received from one circuit element to another circuit element, or may float only to trap the signal thereinside without transferring the signal to the upper source/drain region 422 or the lower source/drain region 412, respectively. This is because the lower source/drain region 412 and the upper source/drain region 422 are electrically isolated from each other by the PN junction structure 411. For example, in a 3DSFET device including a plurality of serially-connected upper source/drain regions including the upper source/drain region 422, a signal received from a left upper source/drain region may pass through the upper source/drain region 422 to a right upper source/drain region depending on the activation status of an NMOS including the right upper source/drain region, without being transferred to the lower source/drain region 412.

Thus, when the P(NPN) structure 40 forms the lower source/drain region 412 and the upper source/drain region 422 as above, an upper source/drain contact plug may not need to be separately formed on the upper source/drain region 422, and instead, the lower source/drain contact plug 417 may be formed on the upper portion of the lower source/drain region 412. Further, a dielectric layer isolating the two source/drain regions 412 and 422 from each other may not be required. Thus, device density and performance as well as manufacturing simplicity may be improved in a 3DSFET device including the P(NPN) structure 40.

Referring to FIG. 4B, formation of the P(NPN) structure 40 may begin with sealing a bottom region of an intermediate 3DSFET structure 400 and growing an upper Epi 422' based on an upper channel structure (not shown) surrounded by a dummy gate structure 415. Next, the 1^{st} semiconductor layer (p-type region 411+) and the 2^{nd} semiconductor layer (n-type region 411-) may be sequentially grown in a similar epitaxy method based on the upper Epi 422'. Subsequently, the sealed lower region of the intermediate 3DSFET structure 400 may be opened, and a lower Epi 412' may be grown based on the 1^{st} and 2^{nd} semiconductor layers and the lower channel structure (not shown) surrounded by the dummy gate structure 415. The lower Epi 412', the 1^{st} and 2^{nd} semiconductor layer, and the upper Epi 422' may eventually form the lower source/drain region 412, the PN junction structure 411 and the upper source/drain region 422, respectively, shown in FIG. 4A.

The substrate 405 may be an Si substrate although it may include other materials such as SiGe, silicon carbide (e.g., SiC), not being limited thereto. The channel structures may include Si or SiGe that may have been epitaxially grown based on the substrate 405.

According to an embodiment, the 1^{st} and 2^{nd} semiconductor layers may be grown based on the upper Epi 412' which is earlier grown, and thus, the 1^{st} and 2^{nd} semiconductor layers may sequentially surround the upper Epi 412'. Further, the upper Epi 412' may be grown based on not only the upper channel structure but the 1^{st} and 2^{nd} semiconductor layer. Thus, at least for this reason, the upper Epi 412' may take a form of surrounding the 1^{st} and 2^{nd} semiconductor layers which surrounds the upper Epi 322', as shown in FIG. 3B.

The lower Epi 412' may be formed of SiGe, and the upper Epi 422' may be formed of Si, for example, not being limited thereto. When the upper Epi 422' and the lower Epi 412' are respectively grown, n-type dopants and p-type dopants may be doped, implanted or diffused in the upper Epi 422' and the lower Epi 412', respectively, to finish the upper Epi 422' and the lower Epi 412' as the n-type upper source/drain region 422 and the p-type lower source/drain region 412, respectively, shown in FIG. 4A. Further, similar p-type dopants and n-type dopants may be doped, implanted or diffused in the 1^{st} and 2^{nd} semiconductor layers to finish these semiconductor layers as the p-type region 411+ and the n-type region 411- of the PN junction structure 411, respectively, shown in FIG. 4A.

The dummy gate structure 415 may be replaced by a replacement metal gate structure later in a step of manufacturing a 3DSFET device including the P(NPN) structure 40.

Provided herebelow are various embodiments of 3DSFET cell architectures in which lower and upper source/drain regions of respective 3DSFET devices are formed of one or more of the PN structure 20, the PNPN structure 30 and the P(NPN) structure 40 shown in FIGS. 2A-2B to 4A-4B. These 3DSFET cell architectures are described in reference to FIGS. 5A-5B through FIGS. 10A-10B in which circuit schematics and channel-length direction views of 3DSFET devices are illustrated. It is understood that each of these structures as well as other structural elements such as a substrate and a channel structure in each of the 3DSFET devices may include the same or similar materials of the corresponding structures, and may function in the same or similar manner as the corresponding structures described above in reference to FIGS. 1 to 4A-4B, and thus, descriptions thereof may be omitted herein.

FIG. 5A illustrates a circuit schematic of a one (1) active contacted poly (gate) pitch (1-CPP) inverter, and FIG. 5B illustrates a simplified cell architecture for the 1-CPP inverter implemented by a 3DSFET device, according to an embodiment.

As shown in FIG. 5A, an inverter circuit may be formed by a PMOS and an NMOS serially connected to each other at one ends thereof, and respectively connected to Vdd and Vss at the other ends thereof. Further, the PMOS and the NMOS are configured to share an input signal from an input node A and output an output signal to an output node Q. The inverter circuit shown in FIG. 5A may form a CMOS inverter.

Referring to FIG. 5B, the CMOS inverter may be implemented by a 3DSFET device 500 which includes a PMOS 50P, formed on a substrate 505, and an NMOS 50N above the PMOS 50P to form a 3DSFET architecture for the CMOS inverter.

The PMOS 50P may include a 1^{st} lower source/drain region 512L and a 2^{nd} lower source/drain region 512R connected to each other through a lower channel structure 510, and the NMOS 50N may include a 1^{st} upper source/drain region 522L and a 2^{nd} upper source/drain region 522R connected to each other through an upper channel structure 520. The 1^{st} lower source/drain region 512L and the 1^{st} upper source/drain region 522L may be isolated from each other through a PN junction structure 511 including a p-type region 511+ and an n-type region 511- in a reverse-biased form. The lower and upper channel structures 510 and 520 may be surrounded by a gate structure 515 when viewed at a channel-width cross-section of the 3DSFET device 500.

For voltage source connection, the 1^{st} lower source/drain region 512L and the 1^{st} upper source/drain region 522L may be connected to Vdd and Vss through a lower source/drain contact plug 517 and a 1^{st} upper source/drain contact plug 527L, respectively. For input node connection, the gate structure 515 may be connected to the input node A through a gate contact plug 537, and, for output node connection, the 2^{nd} upper source/drain contact plug 522R may be connected to the output node Q through a 2^{nd} upper source/drain contact plug 527R.

In the 3DSFET device 500 implementing the CMOS inverter, the 1^{st} lower source/drain region 512L and the 1^{st} upper source/drain region 522L with the PN junction structure 511 therebetween may form a PNPN structure corresponding to the PNPN structure 30 shown in FIG. 3A, and the 2^{nd} lower source/drain region 512R and the 2^{nd} upper source/drain region 522R may form a PN structure corresponding to the PN structure 20 shown in FIG. 2A.

In the PNPN structure, the 1^{st} lower source/drain region 512L and the 1^{st} upper source/drain region 522L may respectively receive a Vdd signal and a Vss signal through the lower source/drain contact plug 517 and the 1^{st} upper source/drain contact plug 527L. Subsequently, the 1^{st} lower source/drain region 512L or the 1^{st} upper source/drain region 522L may transfer the Vdd signal or the Vss signal to the 2^{nd} lower source/drain region 512R or the 2^{nd} upper source/drain region 522R in the PN structure through the lower channel structure 510 or the upper channel structure 520 according to the gate input signal received at a gate structure 515 through a gate contact plug 537 thereon. At this time, the lower source/drain region 512L and the upper source/drain region 522L may be electrically isolated from each other due to the PN junction structure 511 in a reverse-biased condition.

In the PN structure, when the Vdd signal is received at the 2^{nd} lower source/drain region 512R, it may be transferred to the 2^{nd} upper source/drain region 522R through the PN junction between the two source/drain regions 512R and 522R, and output through the 2^{nd} upper source/drain contact plug 527R to the output node Q. In contrast, when the Vss signal is received at the 2^{nd} upper source/drain region 522R of the PN structure, it may be output through the 2^{nd} upper source/drain contact plug 527R to the output node Q. Thus, the 2^{nd} upper source/drain region 522R and the 2^{nd} upper source/drain contact plug 527R thereon may form a common output structure for the Vdd signal and the Vss signal.

For example, when the input node A connected to the 1^{st} gate structure 815R through the gate contact plug 537 is low (receiving an input signal having a logic value 0), the NMOS is turned off and the PMOS is turned on. Thus, the Vdd signal from the 1^{st} lower source/drain region 512L may be transferred to the 2^{nd} lower source/drain region 512R through the lower channel structure 510, and output to the output node Q through the 2^{nd} upper source/drain region 522R and the 2^{nd} upper source/drain contact plug 527R. In contrast, when the input node A is high (receiving an input signal having a logic value 1), the PMOS is turned off and the NMOS is turned on. Thus, the Vss signal from the 1^{st} upper source/drain region 522L may be transferred to the 2^{nd} upper source/drain region 522R through the upper channel structure 520, and output to the output node Q through the 2^{nd} upper source/drain contact plug 527R. Thus, not only the Vss signal received at the 2^{nd} upper source/drain region 522R but also the Vss signal received at the 2^{nd} lower source/drain region 512R may be output to the output node Q through the common output structure including the 2^{nd} upper source/drain region 522R through the 2^{nd} upper source/drain contact plug 527R.

Based on the above PNPN structure and PN structure, the 3DSFET device 500 may form a 3DSFET cell architecture for the CMOS inverter which receive the Vdd signal and the Vss signal at the PNPN structure, and output either of the two signals to the output node Q at the PN structure.

Due to the above PNPN structure and PN structure, the 3DSFET device 500 for the CMOS inverter may not need a dielectric layer for isolating the 1^{st} upper source/drain region 522L from the 1^{st} lower source/drain region 512L, and a lower source/drain contact plug on the 2^{nd} lower source/drain region 512R for outputting the Vss signal therethrough.

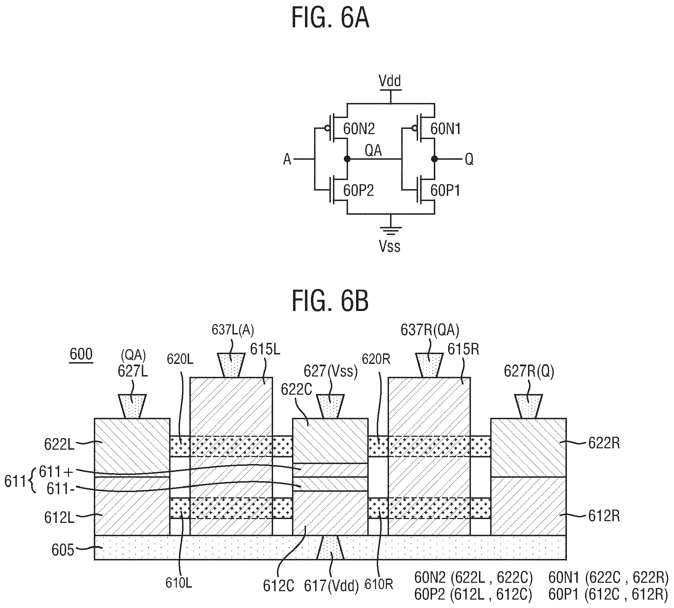

FIG. 6A illustrates a circuit schematic of a 2-CPP inverter, which is a buffer circuit, and FIG. 6B illustrates a simplified standard cell architecture for the buffer circuit implemented by a 3DSFET device, according to an embodiment.

Since a buffer circuit is equivalent to a 2-CPP inverter circuit, a buffer circuit as shown in FIG. 6A may be formed by adding another CMOS inverter to the CMOS inverter shown in FIG. 5A. For example, a PMOS and an NMOS of the added CMOS inverter may share an input signal from an input node A to output a 1^{st} output signal to a 1^{st} output node QA. The output node QA may be an input node of the other CMOS inverter which outputs a 2^{nd} output signal Q to a 2^{nd} output node Q, which is an output node of the buffer circuit. Here, the added CMOS inverter and the other CMOS inverter may respectively form an input CMOS inverter and an output CMOS inverter of the buffer circuit.

Referring to FIG. 6B, the buffer circuit may be implemented by a 3DSFET device 600 which includes, on a substrate 605, a 1^{st} PMOS 60P1, a 1^{st} NMOS 60N1 above the 1^{st} PMOS 60P1, a 2^{nd} PMOS 60P2 on a left side of the 1^{st} PMOS 60P1, and a 2^{nd} NMOS 60N2 above the 2^{nd} PMOS 60P2 to form a 3DSFET cell architecture for the buffer circuit.

In the 3DSFET device 600, the 1^{st} PMOS 60P1 and the 1^{st} NMOS 60N1 may form the output CMOS inverter of the buffer circuit, and have the same structure as that of the PMOS 50P and the NMOS 50N of the 3DSFET 500 for a CMOS inverter in FIG. 5B. Further, the 2^{nd} PMOS 60P2 and the 2^{nd} NMOS 60N2 may form the input CMOS inverter of the buffer circuit, and have the same structure as that of the PMOS 50P and the NMOS 50N of the 3DSFET 500 for the CMOS inverter in FIG. 5B.

Thus, the same PNPN structure and PN structure as those in the 3DSFET device 500 may be formed in each of the output CMOS inverter and the input CMOS inverter of the 3DSFET device 600. However, in the 3DSFET device 600, the output CMOS inverter and the input CMOS inverter share one single PNPN structure. This common PNPN structure may be formed of a 1^{st} lower source/drain region 612C in the 1^{st} PMOS 60P1 and a 1^{st} upper source/drain region 622C in the 1^{st} NMOS 60N1 with a PN junction structure 611 (including a p-type region 611+ and an n-type region 611-) therebetween in a reverse-biased form.

With the PNPN structure at a center, a 1^{st} PN structure for the output CMOS inverter and a 2^{nd} PN structure for the input CMOS inverter may be respectively formed at a right side and a left side of the PNPN structure. The 1^{st} PN structure may be formed of a 2^{nd} lower source/drain region 612R in the 1^{st} PMOS 60P1 and a 2^{nd} upper source/drain region 622R in the 1^{st} NMOS 60N1 with a 2^{nd} upper source/drain contact plug 627R thereon. The 2^{nd} PN structure may be formed of a 3^{rd} lower source/drain region 612L in the 2^{nd} PMOS 60P2 and a 3^{rd} upper source/drain region 622L in the 2^{nd} NMOS 60N2 with a 3^{rd} upper source/drain contact plug 627L thereon.

For voltage source connection of the 3DSFET 600, the 1^{st} lower source/drain region 612C and the 1^{st} upper source/drain region 622C in the PNPN structure may be connected to Vdd and Vss through a lower source/drain contact plug 617 and a 1^{st} upper source/drain contact plug 627C, respectively.

For input node connection of the 3DSFET 600, the 2^{nd} gate structure 615L may be connected to the input node A through a 2^{nd} gate contact plug 637L, and the 1^{st} gate structure 615R may be connected to the 1^{st} output node QA through a 1^{st} gate contact plug 637R.

For output node connection of the 3DSFET device 600, the 3^{rd} upper source/drain region 622L in the 2^{nd} PN structure may be connected to 1^{st} output node QA through the 3^{rd} upper source/drain contact plug 627L, and the 2^{nd} upper source/drain region 622R in the 1^{st} PN structure may be connected to the 2^{nd} output node Q through the 2^{nd} upper source/drain contact plug 627R.

The PNPN structure may receive a Vdd signal and a Vss signal for the output CMOS inverter and the input CMOS inverter through the lower source/drain contact plug 617 and the 1^{st} upper source/drain contact plug 627C.

The 2^{nd} PN structure may receive one of the Vdd signal and the Vss signal from the PNPN structure according to the input signal input from the input node A to the 2^{nd} gate structure 615L through the 2^{nd} gate contact plug 637L. Subsequently, the 2^{nd} PN structure may output the Vdd signal or the Vss signal as the 1^{st} output signal to the 1^{st} output node QA through a common output structure formed of the 3^{rd} upper source/drain region 622L and the 3^{rd} upper source/drain contact plug 627L. Further, the 1^{st} PN structure may receive one of the Vdd signal and the Vss signal according to the 1^{st} output signal as an input signal to the 1^{st} gate structure 615R through the 1^{st} gate contact plug 637R. Subsequently, the 1^{st} PN structure may output the Vdd signal or the Vss signal to the 2^{nd} output node Q through a common output structure formed of the 2^{nd} upper source/drain region 622R and the 2^{nd} upper source/drain contact plug 627R

Due to the above PNPN structure and 1^{st} and 2^{nd} PN structures, the 3DSFET device 600 for the buffer circuit may not need a dielectric layer for isolating the 1^{st} upper source/drain region 622C from the 1^{st} lower source/drain region 612C, and a lower source/drain contact plug on each of the 2^{nd} lower source/drain region 612R and the 3^{rd} lower source/drain region 612L for outputting the Vss signals therethrough.

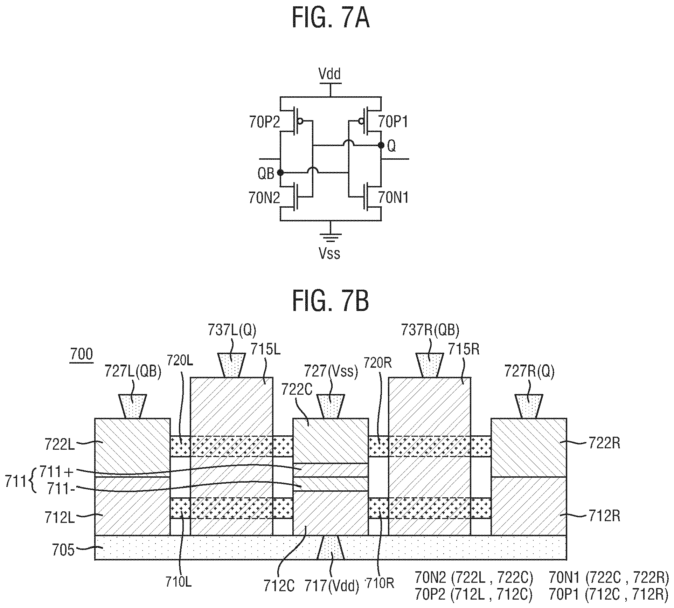

FIG. 7A illustrates a circuit schematic of a 2-CPP cross-couple circuit, and FIG. 7B illustrates a simplified standard cell architecture for the cross-couple circuit implemented by a 3DSFET device, according to an embodiment.

In the cross-couple circuit shown in FIG. 7A, two CMOS inverters are crosscoupled such that a 1^{st} output node Q of a 1^{st} CMOS inverter is connected to a gate of a 2^{nd} CMOS inverter, and a 2^{nd} output node QB of a 2^{nd} CMOS inverter is connected to a gate of the 1^{st} CMOS inverter. The cross-couple circuit is known to be heavily used in designing an integrated circuit including a static random access memory (SRAM).

Referring to FIG. 7B, the cross-couple circuit may be implemented by a 3DSFET device 700 which may include, on a substrate 705, a 1^{st} PMOS 70P1, a 1^{st} NMOS 70N1 above the 1^{st} PMOS 70P1, a 2^{nd} PMOS 70P2 on a left side of the 1^{st} PMOS 70P1, and a 2^{nd} NMOS 70N2 above the 2^{nd} PMOS 70P2 to form a 3DSFET cell architecture for the cross-couple circuit. Since the cross-couple circuit shown in FIG. 7A has a reverse structure of a buffer circuit shown in FIG. 6A, the 3DSFET 700 implementing the cross-couple circuit may have the same structure as the 3DSFET 600 implementing the buffer circuit as shown in FIGS. 6A and 6B, except crosscoupled input/output connection structures.

In the 3DSFET device 700, the 1^{st} PMOS 70P1 and the 1^{st} NMOS 70N1 may form the 1^{st} CMOS inverter of the cross-couple circuit, and have the same structure as that of the 1^{st} PMOS 60P1 and the 1^{st} NMOS 60N1 of the 3DSFET 600 for a buffer circuit in FIG. 6B. Further, the 2^{nd} PMOS 70P2 and the 2^{nd} NMOS 70N2 may form the 2^{nd} CMOS inverter of the cross-couple circuit, and have the same structure as that of the 2^{nd} PMOS 60P2 and the 2^{nd} NMOS 60N2 of the 3DSFET 600 for the buffer circuit in FIG. 6B.

Thus, the same PNPN structure and the 1^{st} and 2^{nd} PN structures formed in the 3DSFET device 600 for the buffer circuit may be formed by the following structures in the 3DSFET device 700: 1^{st}, 2^{nd} and 3^{rd} lower source/drain regions 712C, 712R and 712L, 1^{st}, 2^{nd} and 3^{rd} upper source/drain regions 722C, 722R and 722L, 1^{st} lower and upper channel structures 710R and 720R, 2^{nd} lower and upper channel structures 710L and 720L, a PN junction structure 711 including a p-type region 711+ and an n-type region 711-, a lower source/drain contact plug 717, 1^{st}, 2^{nd} and 3^{rd} upper source/drain contact plugs 727C, 727R and 727L, 1^{st} and 2^{nd} gate structures 715R and 715L, and 1^{st} and 2^{nd} gate contact plugs 737R and 737L. Here, the 1^{st} and 2^{nd} lower source/drain regions 712C and 712R may form the 1^{st} PMOS 70P1, the 1^{st} and 2^{nd} upper source/drain regions 722C and 722R may form the 2^{nd} NMOS 70N1. Further, the 1^{st} and 3^{rd} lower source/drain region 712C and 712L may form the 2^{nd} PMOS 70P2, and the 1^{st} and 3^{rd} upper source/drain regions 722C and the 772L may form the 2^{nd} NMOS 70N2.

For voltage source connection of the 3DSFET 700, the 1^{st} lower source/drain region 712C and the 1^{st} upper source/drain region 722C in the PNPN structure may be connected to Vdd and Vss through a lower source/drain contact plug 717 and a 1^{st} upper source/drain contact plug 727C, respectively.

For input node connection of the 3DSFET device 700, the 1^{st} gate structure 715R may be connected to the 2^{nd} output node QB through a 1^{st} gate contact plug 737R, and the 2^{nd} gate structure 715L may be connected to the 1^{st} output node Q through a 2^{nd} gate contact plug 737L.

For output node connection, the 2^{nd} upper source/drain region 722R in the 1^{st} PN structure may be connected to the 1^{st} output node Q through the 2^{nd} upper source/drain contact plug 727R, and the 3^{rd} upper source/drain region 722L in the 2^{nd} PN structure may be connected to 2^{nd} output node QB through the 3^{rd} upper source/drain contact plug 627L.

To implement the cross-couple connection in the cross-couple circuit, a 1^{st} output signal of the 1^{st} CMOS inverter (1^{st} PMOS 70P1 and 1^{st} NMOS 70N1) output from the 2^{nd} upper source/drain region 722R through the 2^{nd} upper source/drain contact plug 727R may be input to the 2^{nd} gate structure 715L through the 2^{nd} gate contact plug 737L (connected to 1^{st} output node Q). Further, a 2^{nd} output signal of a 2^{nd} CMOS inverter (2^{nd} PMOS 70P2 and 2^{nd} NMOS 70N2) from the 3^{rd} upper source/drain region 722L may be input to the 1^{st} gate structure 715R through the 1^{st} gate contact plug 737R (connected to 2^{nd} output node QB).

Thus, the 3DSFET device 700 implementing the cross-couple circuit may dispense with a dielectric layer for isolating the 1^{st} lower source/drain region 712C and the 1^{st} upper source/drain region 722C from each other, and a lower source/drain contact plug on each of the 2^{nd} lower source/drain region 712R and the 3^{rd} lower source/drain region 712L for outputting the Vss signals therethrough.

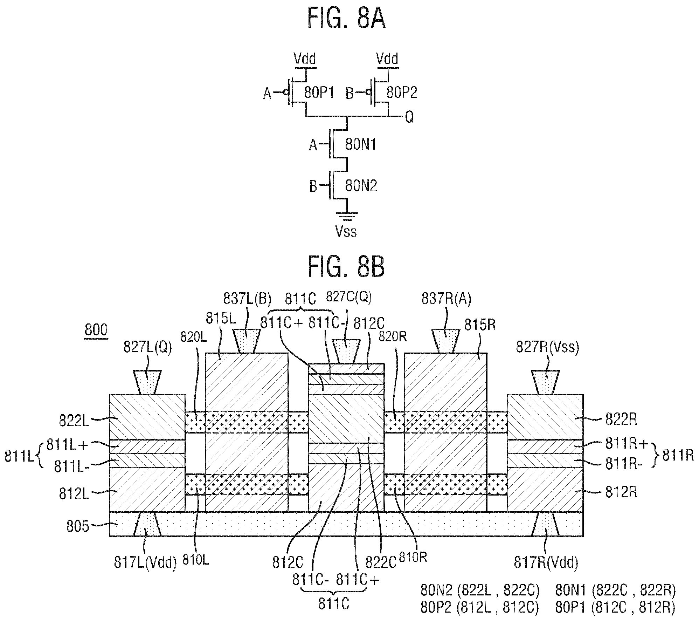

FIG. 8A illustrates a circuit schematic of a 2-CPP NAND2 circuit, and FIG. 8B illustrates a simplified standard cell architecture for the NAND2 circuit implemented by a 3DSFET device, according to an embodiment.

Referring to FIG. 8A, the NAND2 circuit may be formed of a 1^{st} PMOS 80P1 and a 2^{nd} PMOSs 80P2, connected to each other in parallel, and a 1^{st} NMOS 80N1 and a 2^{nd} NMOS 80N2 connected to each other in series. The 1^{st} and 2^{nd} PMOSs 80P1 and 80P2 respectively receive 1^{st} and 2^{nd} input signals from 1^{st} and 2^{nd} input nodes A and B, and are commonly connected to Vdd at one end and an output node Q at the other end. The serially-connected 1^{st} and 2^{nd} NMOSs 80N1 and 80N2 respectively receive the same 1^{st} and 2^{nd} input signals from the same 1^{st} and 2^{nd} input nodes A and B as the 1^{st} and 2^{nd} PMOSs 80P1 and 80P2, and are connected to the output node Q at one end and Vss at the other end.

Referring to FIG. 8B, a 3DSFET device 800 implementing the NAND2 circuit may include, on a substrate 805, the 1^{st} PMOS 80P1, the 1^{st} NMOS 80N1 above the 1^{st} PMOS 80P1, the 2^{nd} PMOS 80P2 on a left side of the 1^{st} PMOS 80P1, and the 2^{nd} NMOS 80N2 above the 2^{nd} PMOS 80P2 to form a 3DSFET architecture for the NAND2 circuit.

The 1^{st} PMOS 80P1 may include a 1^{st} lower source/drain region 812C and a 2^{nd} lower source/drain region 812R connected to each other through a 1^{st} lower channel structure 810R, and the 1^{st} NMOS 80N1 may include a 1^{st} upper source/drain region 822C and a 2^{nd} upper source/drain region 822R connected to each other through a 1^{st} upper channel structure 820R.

The 1^{st} lower source/drain region 812C and the 1^{st} upper source/drain region 822C may be isolated from each other through a 1^{st} PN junction structure 811C including a p-type region 811C+ and an n-type region 811C- in a reverse-biased form. Further, an upper portion of the 1^{st} PN junction structure 811C may be formed above the 1^{st} upper source/drain region 822C, and an upper portion of the 1^{st} lower source/drain region 812C may be formed above the upper portion of the 1^{st} PN junction structure 811C above the 1^{st} upper source/drain region 822C. The 1^{st} lower source/drain region 812C and the 1^{st} upper source/drain region 822C with 1^{st} the PN junction structure 811C therebetween may form a P(NPN) structure corresponding to the P(NPN) structure 40 shown in FIG. 4A. Thus, the 1^{st} upper source/drain region 822C may be surrounded by the 1^{st} PN junction structure 811C, which is surrounded by the 1^{st} lower source/drain region 812C. As the upper portion of the 1^{st} lower source/drain region 812C may be formed above the 1^{st} upper source/drain region 822C and the upper portion of the 1^{st} PN junction structure 811C, a 1^{st} lower source/drain contact plug 817C may be formed on the upper portion of the 1^{st} lower source/drain region 812C instead of a bottom surface or a side surface thereof.

The 2^{nd} lower source/drain region 812R and the 2^{nd} upper source/drain region 822R may be isolated from each other through a 2^{nd} PN junction structure 811R including a p-type region 811R+ and an n-type region 811R- in a reverse-biased form, thereby forming a 1^{st} PNPN structure corresponding to the PNPN structure 30 shown in FIG. 3A.

The 1^{st} lower and upper channel structures 810R and 820R may be surrounded by a 1^{st} gate structure 815R when viewed at a channel-width cross-section of the 3DSFET device 800.

The 2^{nd} PMOS 80P2 may include the 1^{st} lower source/drain region 812C and a 2^{nd} lower source/drain region 812L connected to each other through a 2^{nd} lower channel structure 810L, and the 2^{nd} NMOS 80N2 may include the 1^{st} upper source/drain region 822C and a 3^{rd} upper source/drain region 822L connected to each other through a 2^{nd} upper channel structure 820L. Here, the 1^{st} lower source/drain region 812C may be shared by the 1^{st} PMOS 80P1 and the 2^{nd} PMOS 80P2, and the 1^{st} upper source/drain region 822C may be shared by the 1^{st} NMOS 80N1 and the 2^{nd} NMOS 80N2.

The 3^{rd} lower source/drain region 812L and the 3^{rd} upper source/drain region 822L may be isolated from each other through a 3^{rd} PN junction structure 811L including a p-type region 811L+ and an n-type region 811L- in a reverse-biased form, thereby forming a 2^{nd} PNPN structure corresponding to the PNPN structure 30 shown in FIG. 3A.

The 2^{nd} lower and upper channel structures 810L and 820L may be surrounded by a 2^{nd} gate structure 815R when viewed at a channel-width cross-section of the 3DSFET device 800.

For voltage source connection, the 2^{nd} lower source/drain region 812R and the 2^{nd} upper source/drain region 822R in the 1^{st} PNPN structure may be connected to Vdd and Vss through a 2^{nd} lower source/drain contact plug 817R and a 2^{nd} upper source/drain contact plug 827R, respectively, and further, the 3^{rd} lower source/drain region 812L in the 2^{nd} PNPN structure may also be connected to Vdd through a 2^{nd} lower source/drain contact plug 817L.

For input node connection, the 1^{st} input node A and the 2^{nd} input node B may be respectively connected to the 1^{st} gate structure 815R and the 2^{nd} gate structure 815L through a 1^{st} gate contact plug 837R and a 2^{nd} gate contact plug 837L, respectively.

For output node connection, the output node Q may be connected to the 3^{rd} upper source/drain region through the 3^{rd} upper source/drain contact plug 827L, which may be connected to the upper portion of the 1^{st} lower source/drain region 812C through the 1^{st} upper source/drain contact plug 827C in the P(NPN) structure.

In the 1^{st} PNPN structure, the 2^{nd} lower source/drain region 812R and the 2^{nd} upper source/drain region 822R may respectively receive a Vdd signal and a Vss. Subsequently, the 2^{nd} lower source/drain region 812R or the 2^{nd} upper source/drain region 822R may transfer the Vdd signal or the Vss signal to the 1^{st} lower source/drain region 812C or the 1^{st} upper source/drain region 822C through the 1^{st} lower channel structure 810R or the 1^{st} upper channel structure 820R according to the 1^{st} input signal from the 1^{st} input node A. At this time, the 2^{nd} lower source/drain region 812R and the 2^{nd} upper source/drain region 822R may be electrically isolated from each other due to the 2^{nd} PN junction structure 811R in a reverse-biased condition.

In the 2^{nd} PNPN structure, the 3^{rd} lower source/drain region 812L may receive the Vdd signal, and transfer the Vdd signal to the 1^{st} lower source/drain region 812C in the P(NPN) structure through the 2^{nd} lower channel structure 810L according to the 2^{nd} input signal from the 2^{nd} input node B. At this time, the 3^{rd} lower source/drain region 812L and the 3^{rd} upper source/drain region 822L may be electrically isolated from each other due to the 3^{rd} PN junction structure 811L in a reverse-biased condition.

In the P(NPN) structure, when the Vdd signal is received at the 1^{st} lower source/drain region 812C from the 2^{nd} lower source/drain region 812R or the 3^{rd} lower source/drain region 812L, the Vdd signal may be transferred to the upper portion of the 1^{st} lower source/drain region 812C formed above the 1^{st} upper source/drain region 822C with the upper portion of the 1^{st} PN junction structure 811C therebetween. This is because the P(NPN) structure in the 3DSFET 800 may take the same form as the P(NPN) structure 40 shown in FIG. 4B. The Vdd signal transferred to the upper portion of the 1^{st} lower source/drain region 812C may be output to the output node Q through the 1^{st} upper source/drain contact plug 827C.

In contrast, when the Vss signal is received at the 1^{st} upper source/drain region 822C from the 2^{nd} upper source/drain region 822R, the 1^{st} upper source/drain region 822C surrounded by or electrically isolated from the 1^{st} lower source/drain region 812C may pass (or relay) the Vss signal to the 3^{rd} upper source/drain region 822L or float only to trap the Vss signal inside the 1^{st} upper source/drain region 822C depending on the activation status of the 2^{nd} NMOS 80N2 including the 3^{rd} upper source/drain region 822L.

For example, the 1^{st} input node A may be high (receiving an input signal having a logic value 1) and the 2^{nd} input node B may be low (receiving an input signal having a logic value 0). In this case, the 1^{st} PMOS 80P1 and the 2^{nd} NMOS 80N2 may be deactivated while the 2^{nd} PMOS 80P2 and the 1^{st} NMOS 80N1 may be activated. Thus, in the activated 1^{st} NMOS 80N1, the Vss signal input to the 2^{nd} upper source/drain region 822R may be transferred to the 1^{st} upper source/drain region 822C through the 1^{st} upper channel structure 820R. However, this Vss signal may not pass through the 1^{st} upper source/drain region 822C to the 3^{rd} upper source/drain region 822L of the deactivated 2^{nd} NMOS 80N2 because of the 1^{st} PN junction structure 811C in a reverse biased condition, and may also not be output to the output node Q through the 1^{st} upper source/drain contact plug 827C also because of the 1^{st} PN junction structure 811C. In contrast, in the activated 2^{nd} PMOS 80P2, a Vdd signal (a logic value 1) input to the 3^{rd} lower source/drain region 812L may be transferred to the 1^{st} lower source/drain region 812C through the 2^{nd} lower channel structure 810L, and transferred to the upper portion of the 1^{st} lower source/drain region 812C to be output to the output node Q through the 1^{st} upper source/drain contact plug 827C due to the P(NPN) structure.

As another example, when both the 1^{st} input node A and the 2^{nd} input node B are high, the 1^{st} PMOS 80P1 and the 2^{nd} PMOS 80P2 may be deactivated while the 1^{st} NMOS 80N1 and the 2^{nd} NMOS 80N2 are activated. In this case, a Vss signal input to the 2^{nd} upper source/drain region 822R of the 1^{st} NMOS 80N1 may be transferred to the 3^{rd} upper source/drain region 822L of the 2^{nd} NMOS 80N2 through the 1^{st} upper source/drain region 822C shared by the two NMOSs 80N1 and 80N2 due to the 1^{st} PN junction structure in the P(NPN) structure. Then, the Vss signal (a logic value 0) may be transferred to the 3^{rd} upper source/drain region 822L to be output to the output node Q through the 3^{rd} upper source/drain contact plug 827L.

Thus, when the P(NPN) structure is used in the 3DSFET device 800 for the NAND2 circuit, an upper source/drain contact plug may not need to be separately formed on the 1^{st} upper source/drain region 822C, and a dielectric layers for isolating the lower source/drain region 812C from the upper source/drain region 822C may not be required..

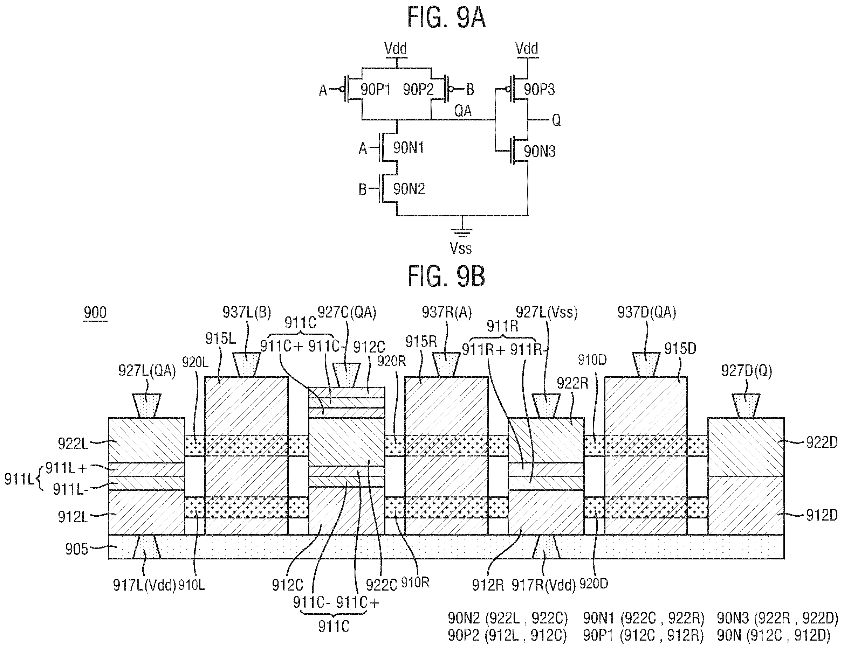

FIG. 9A illustrates a circuit schematic of a 3-CPP AND2 circuit, and FIG. 9B illustrates a simplified standard cell architecture for the AND2 circuit implemented by a 3DSFET device, according to an embodiment.

As shown in FIG. 9A, the AND2 circuit is formed by adding the CMOS inverter shown in FIG. 5A to the NAND2 circuit shown in FIG. 8A such that the output node Q of the NAND2 circuit is connected to the two gates of the PMOS and the NMOS forming the CMOS inverter. Thus, the AND2 circuit of FIG. 9A includes a NAND block corresponding to the NAND2 circuit and an inverter block corresponding to the CMOS inverter. Similar to the NAND2 circuit, the NAND block has two 1^{st} and 2^{nd} input nodes A and B, and an output node, which is a 1^{st} output node QA of the AND2 circuit. Respective 1^{st} and 2^{nd} input signals from the 1^{st} and 2^{nd} input nodes A and B may be input to the NAND block to output a 1^{st} output signal to the 1^{st} output node QA. The 1^{st} output signal may be input to the inverter block to output a 2^{nd} output signal to a 2^{nd} output node Q of the AND2 circuit.

Referring to FIG. 9B, the AND2 circuit may be implemented by a 3DSFET device 900 which includes, on a substrate 905, a 1^{st} PMOS 90P1, a 1^{st} NMOS 90N1 formed above the 1^{st} PMOS 90P1, a 2^{nd} PMOS 90P2 on a left side of the 1^{st} PMOS 90P1, a 2^{nd} NMOS 90N2 above the 2^{nd} PMOS 90P2, a 3^{rd} PMOS 90P3 on a right side of the 1^{st} PMOS 90P1, and a 3^{rd} NMOS 90N3 on the 3^{rd} PMOS 90P3.

Here, the 1^{st} and 2^{nd} PMOSs 90P1 and 90P2, and the 1^{st} and 2^{nd} NMOSs 90N1 and 90N2 form the NAND block which has the same architecture as the 3DSFET device 800 for the NAND2 circuit 800 as shown in FIG. 8B. Further, the 3^{rd} PMOS 90P3 and the 3^{rd} NMOS 90N3 form the inverter block which has the same architecture as the 3DSFET device for the CMOS inverter as shown in FIG. 5B. Thus, in the 3DSFET device 900, the same P(NPN) structure and 1^{st} and 2^{nd} PNPN structures as those in the 3DSFET device 800 for the NAND2 circuit may be formed for the NAND block, and the same PNPN structure and PN structure as those in the 3DSFET device 500 for the CMOS inverter may be formed for the inverter block. However, the inverter block may share, as its PNPN structure, the 1^{st} PNPN structure of the NAND block connected to Vdd and Vss.

The 1^{st} PNPN structure as a common PNPN structure for the NAND block and the inverter block in the 3DSFET device 900 may include a 2^{nd} lower source/drain region 912R in the 1^{st} PMOS 90P1 and a 2^{nd} upper source/drain region 922R in the 1^{st} NMOS 90N1 with a 2^{nd} PN junction structure 911R (including a p-type region 911R+ and an n-type region 911R-) therebetween in a reverse-biased form. The PN structure for the inverter block may include a 4^{th} lower source/drain region 912D in the 3^{rd} PMOS 90P3 and a 4^{th} upper source/drain region 922D in the 3^{rd} NMOS 90N3, which are connected to the 2^{nd} lower source/drain region 912R in the 1^{st} PMOS 90P1 and the 2^{nd} upper source/drain region 922R in the 1^{st} NMOS 90N1 through a 3^{rd} lower channel structure 910D and a 3^{rd} upper channel structure 920D, respectively. The 3^{rd} lower channel structure 910D and the 3^{rd} upper channel structure 920D may be surrounded by a 3^{rd} gate structure 915D.

Also similar to the 3DSFET device 800, the P(NPN) structure in the 3DSFET device 900 may include a 1^{st} lower source/drain region 912C in the 1^{st} PMOS 90P1 and a 1^{st} upper source/drain region 922C with a 1^{st} PN junction structure 911C (including a p-type region 911C+ and an n-type region 911C-) therebetween in a reverse-biased form. Further, the 2^{nd} PNPN structure may include the 3^{rd} lower source/drain region 912L and the 3^{rd} upper source/drain region 922L with a 3^{rd} PN junction structure 911L (including a p-type region 911L+ and an n-type region 911L-) therebetween in a reverse-biased form.

For voltage source connection, the 2^{nd} lower source/drain region 922R and the 2^{nd} upper source/drain region 922R in the 1^{st} PNPN structure may be connected to Vdd and Vss through a 2^{nd} lower source/drain contact plug 917R and a 2^{nd} upper source/drain contact plug 927R, and further, the 3^{rd} lower source/drain region 912L in the 2^{nd} PNPN structure may also be connected to Vdd through a 2^{nd} lower source/drain contact plug 917L.

For input/output connection, the 1^{st} input node A and the 2^{nd} input node B may be connected to the 1^{st} gate structure 915R and the 2^{nd} gate structure 915L through a 1^{st} gate contact plug 937R and a 2^{nd} gate contact plug 937L, respectively.

For output node connection, the 1^{st} output node may be connected to the 3^{rd} upper source/drain region through the 3^{rd} upper source/drain contact plug, which may be connected to an upper portion of the 1^{st} upper source/drain region 912C through the 1^{st} upper source/drain contact plug 927C. Further, this 1^{st} output node QA as an input node of the inverter block of the AND2 circuit may be connected to the 3^{rd} gate structure 915D through a 3^{rd} gate contact plug 937D, and the 2^{nd} output node Q of the AND2 circuit may be connected to the 4^{th} upper source/drain region 922D through a 4^{th} upper source/drain contact plug 927D.

In the 1^{st} PNPN structure in the NAND block, the 1^{st} lower source/drain region 912C and the 1^{st} upper source/drain region 922C may receive a Vdd signal and a Vss signal, respectively. The Vdd signal or the Vss signal may be transferred to the PN structure in the inverter block according to the 1^{st} output signal of the 1^{st} output node QA. When the Vdd signal or the Vss signal is received or transferred out, the 1^{st} upper source/drain region 1022C and the 1^{st} lower source/drain region 1012C may be electrically isolated from each other due to the 1^{st} PN junction structure 911C in a reverse-biased condition.

In the PN structure in the inverter block, the Vdd signal transferred to the 4^{th} lower source/drain region 912D may pass through the 4^{th} upper source/drain region 922D to be output to the 2^{nd} output node Q, or the Vss signal transferred to the 4^{th} upper source/drain region 922D may be output to the 2^{nd} output node Q.

As in the 3DSFET devices 500, 600 and 700, the PN structure formed of the 4^{th} lower source/drain region 912D and the 4^{th} upper source/drain region 922D may also dispense with a dielectric layer, for isolating the two source/drain regions 912D and 922D, and a lower source/drain contact plug on the lower source/drain region 912 for outputting the Vss signal therefrom.

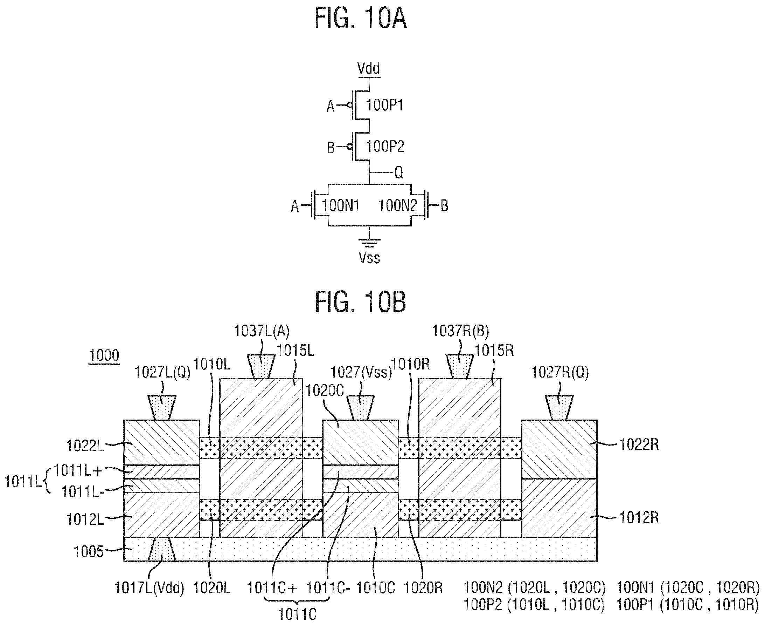

FIG. 10A illustrates a circuit schematic of a 2-CPP NOR2 circuit, and FIG. 10B illustrates a simplified standard cell architecture for the NOR2 circuit implemented by a 3DSFET device, according to an embodiment.

Referring to FIG. 10A, the NOR2 circuit may be formed of a 1^{st} PMOS 100P1 and a 2^{nd} PMOSs 100P2, connected to each other in series, and a 1^{st} NMOS 100N1 and a 2^{nd} NMOS 100N2 connected to each other in parallel. The serial-connected 1^{st} and 2^{nd} PMOSs 100P1 and 100P2 respectively receive 1^{st} and 2^{nd} input signals from 1^{st} and 2^{nd} input nodes A and B, and are connected to Vdd at one end and an output node Q at the other end. The parallel-connected 1^{st} and 2^{nd} NMOSs 100N1 and 100N2 respectively receive the same 1^{st} and 2^{nd} input signals from the same 1^{st} and 2^{nd} input nodes A and B as the 1^{st} and 2^{nd} PMOSs 100P1 and 100P2, and are commonly connected to Vss at one end and an output node Q at the other end thereof.

Referring to FIG. 10B, a 3DSFET device 1000 implementing the NOR2 circuit may include, on a substrate 1005, the 1^{st} PMOS 100P1, the 1^{st} NMOS 100N1 above the 1^{st} PMOS 100P1, the 2^{nd} PMOS 100P2 on a right side of the 1^{st} PMOS 100P1, and the 2^{nd} NMOS 100N2 above the 2^{nd} PMOS 100P2 to form a 3DSFET architecture for the NOR2 circuit. Here, the 2^{nd} PMOS 100P2 and the 2^{nd} NMOS 100N2 are at not the left side but the right side of the 1^{st} PMOS 100P1 and the 1^{st} NMOS 100N1, respectively. This PMOS/NMOS arrangement in the 3DSFET device 1000 for the NOR2 circuit is opposite to that in the 3DSFET device 900 of the NAND2 circuit. However, this is only an example, and the disclosure is not limited thereto. The 3DSFET device 1000 may be formed using the same PMOS/NMOS arrangement in the 3DSFET device 900, according to an embodiment.

The 1^{st} PMOS 100P1 may include a 1^{st} lower source/drain region 1012C and a 3^{rd} lower source/drain region 1012L connected to each other through a 2^{nd} lower channel structure 1010L, and the 1^{st} NMOS 100N1 may include a 1^{st} upper source/drain region 1022C and a 3^{rd} upper source/drain region 1022L connected to each other through a 2^{nd} upper channel structure 1020L.

The 1^{st} lower source/drain region 1012C and the 1^{st} upper source/drain region 1022C may be isolated from each other through a 1^{st} PN junction structure 1011C including a p-type region 1011C+ and an n-type region 1011C- in a reverse-biased form. Thus, the 1^{st} lower source/drain region 1012C and the 1^{st} upper source/drain region 1022C with 1^{st} the PN junction structure 911C therebetween may form a 1^{st} PNPN structure corresponding to the PNPN structure 30 shown in FIG. 3A.

The 3^{rd} lower source/drain region 1012L and the 3^{rd} upper source/drain region 1022L may be isolated from each other through a 2^{nd} PN junction structure 1011L including a p-type region 1011L+ and an n-type region 1011L- in a reverse-biased form, thereby forming a 2^{nd} PNPN structure corresponding to the PNPN structure 30 shown in FIG. 3A.

The 2^{nd} lower and upper channel structures 1010L and 1020L may be surrounded by a 2^{nd} gate structure 1015L when viewed at a channel-width cross-section of the 3DSFET device 1000.

The 2^{nd} PMOS 100P2 may include the 1^{st} lower source/drain region 1012C and a 2^{nd} lower source/drain region 1012R connected to each other through a 1^{st} lower channel structure 1010R, and the 2^{nd} NMOS 100N2 may include the 1^{st} upper source/drain region 1022C and a 2^{nd} upper source/drain region 1022R connected to each other through a 2^{nd} upper channel structure 1020R. Here, the 1^{st} lower source/drain region 1012C may be shared by the 1^{st} PMOS 100P1 and the 2^{nd} PMOS 100P2, and the 1^{st} upper source/drain region 1022C may be shared by the 1^{st} NMOS 100N1 and the 2^{nd} NMOS 100N2. The 2^{nd} lower source/drain region 1012R and the 2^{nd} upper source/drain region 1022R may form a PN structure corresponding to the PN structure 20 shown in FIG. 2A.

The 1^{st} lower and upper channel structures 1010R and 1020R may be surrounded by a 1^{st} gate structure 1015R when viewed at a channel-width cross-section of the 3DSFET device 1000.

For voltage source connection, the 3^{rd} lower source/drain region 1022L in the 2^{nd} PNPN structure and the 1^{st} upper source/drain region 1022C 1^{st} PNPN structure may be connected to Vdd and Vss through a lower source/drain contact plug 1017 and a 1^{st} upper source/drain contact plug 1027C, respectively.

For input node connection, the 1^{st} input node A and the 2^{nd} input node B may be connected to the 2^{nd} gate structure 1015L and the 1^{st} gate structure 1015R through a 2^{nd} gate contact plug 1037L and a 1^{st} gate contact plug 1037R, respectively.

For output node connection, the output node Q may be connected to both of the 2^{nd} upper source/drain region 1022R in the PN structure and the 3^{rd} upper source/drain region 1022L in the 2^{nd} PNPN structure through a 2^{nd} upper source/drain contact plug 1027R and a 3^{rd} upper source/drain contact plug 1027L, respectively. Thus, an output signal of the NOR2 circuit may be output from either of the 2^{nd} upper source/drain region 1022R and the 3^{rd} upper source/drain region 1022L

In the 1^{st} PNPN structure, the 1^{st} upper source/drain region 1022C may receive a Vss signal through the 1^{st} upper source/drain contact plug 1027C. The 1^{st} upper source/drain region 1022C may transfer the Vss signal to the 2^{nd} upper source/drain region 1022R in the PN structure through the 1^{st} upper channel structure 1020R according to the 2^{nd} input signal of the 2^{nd} input node B. Alternatively or additionally, the 1^{st} upper source/drain region 1022C may transfer the Vss signal to the 3^{rd} upper source/drain region 1022L in the 2^{nd} PNPN structure through the 2^{nd} upper channel structure 1020L according to the 1^{st} input signal of the 1^{st} input node A. Further, in the 1^{st} PNPN structure, the 1^{st} lower source/drain region 1012C may pass (or relay) a Vdd signal transferred from the 3^{rd} lower source/drain region 1012L to the 2^{nd} lower source/drain region 1012R through the 1^{st} lower channel structure 1010R, or may float without transferring out the Vdd signal, according to the input signal of the input node B input to the 1^{st} gate structure 1015R. When the Vss signal or the Vdd signal is transferred out or received, the 1^{st} upper source/drain region 1022C and the 1^{st} lower source/drain region 1012C may be electrically isolated from each other due to the 1^{st} PN junction structure 1011C in a reverse-biased condition.

In the 2^{nd} PNPN structure, the 3^{rd} upper source/drain region 1022L may receive the Vss signal from the 1^{st} upper source/drain region 1022C and output the Vss signal to the output node Q through the 3^{rd} upper source/drain contact plug 1027L. Further, the 3^{rd} lower source/drain region 1012L may receive and transfer the Vdd signal to the 1^{st} lower source/drain region 1012L according to the input signal of the input node A input to the 2^{nd} gate structure 1015L.

In the PN structure, the Vss signal transferred to the 2^{nd} upper source/drain region 1022R may be output to the output node Q through the 2^{nd} upper source/drain contact plug 1027R, or the Vdd signal transferred to the 2^{nd} lower source/drain region 1012R may pass through the 2^{nd} upper source/drain region 1022R to be output to the output node Q through the 2^{nd} upper source/drain contact plug 1027R.

For example, when the 1^{st} input node A is low (receiving an input signal having a logic value 0), and the 2^{nd} input node B is high (receiving an input signal having a logic value 1), the 1^{st} PMOS 100P1 and the 2^{nd} NMOS 100N2 may be activated while the 2^{nd} PMOS 100P2 and the 1^{st} NMOS 100N1 are deactivated. Thus, in the activated 1^{st} PMOS 100P1, a Vdd signal input to the 3^{rd} lower source/drain region 1012L may be transferred to the 1^{st} lower source/drain region 1012C through the 2^{nd} lower channel structure 1010L. This Vdd signal may not pass through the 1^{st} lower source/drain region 1012C to the 2^{nd} lower source/drain region 1012R of the deactivated 1^{st} PMOS 100P2, and may also not be transferred to the 1^{st} upper source/drain region 1022C due to the 1^{st} PN junction structure in a reverse biased condition. In contrast, in the activated 2^{nd} NMOS 100N2, a Vss signal (a logic value 0) input to the 1^{st} upper source/drain region 1022C may be transferred to the 2^{nd} upper source/drain region 1022R through the 1^{st} upper channel structure 1020R, and output to the output node Q through the 2^{nd} upper source/drain contact plug 1027R due to the PN structure.

As another example, when both the 1^{st} input node A and the 2^{nd} input node B are low, the 1^{st} PMOS 100P1 and the 2^{nd} PMOS 100P2 may be activated while the 1^{st} NMOS 100N1 and the 2^{nd} NMOS 100N2 are deactivated. In this case, a Vdd signal input to the 3^{rd} lower source/drain region 1012L of the 1^{st} PMOS 100P1 may be transferred to the 2^{nd} lower source/drain region 1012R of the 2^{nd} PMOS 100P2 through the 1^{st} lower source/drain region 1012C shared by the two PMOSs 100P1 and 100P2 due to the 1^{st} PN junction structure. This Vdd signal transferred to the 2^{nd} lower source/drain region 1012R may be transferred to the 2^{nd} upper source/drain region 1022R to be output to the output node Q through the 2^{nd} upper source/drain contact plug 1027R due to the PN structure.

Thus, when the 1^{st} and 2^{nd} PNPN structures and the PN structure are used in the 3DSFET device 1000 for the NOR2 circuit, a lower source/drain contact plug may not need to be separately formed on the 1^{st} lower source/drain region 1012C and the 2^{nd} lower source/drain region 1012R. Further, dielectric layers may also not be required in the 1^{st} and 2^{nd} PNPN structure and the PN structure.

Thus far, various embodiments of 3DSFET devices implementing a CMOS inverter, a buffer circuit, a cross-couple circuit, a NAND2 circuit, an AND2 circuit, and a NOR2 circuit have been presented. As described above, when each of these 3DSFET devices includes the PN structure 20 of FIG. 2A, the PNPN structure 30 of FIG. 3A or the P(NPN) structure 40 of FIG. 4A to form a lower source/drain region and an upper source/drain region, it may not be necessary or required to form at least one of a lower source/drain contact plug and an upper source/drain contact plug on the lower source/drain region or the upper source/drain region for connection to a voltage source, an input node or an output node. Further, each of these 3DSFETs may not need or require a dielectric layer for isolating the lower source/drain region and the upper source/drain region from each other. Thus, these 3DSFET device may achieve improved device density and performance as well as manufacturing simplicity.

It is understood that the disclosure is not limited to the above embodiments of the 3DSFET devices for the CMOS inverter, the buffer circuit, the cross-couple circuit, the NAND2 circuit, the AND2 circuit and the NOR2 circuit as shown in FIGS. 5A-5B to 10A-10B. The disclosure may also apply to 3DSFET devices implementing different forms of the above logic circuits, and further, other logic circuits.

In the above embodiments, each of the 3DSFET devices is formed of a PMOS at a lower stack and an NMOS at an upper stack. However, the disclosure may also apply to 3DSFET devices formed of an NMOS and a PMOS at a lower stack and an upper stack, respectively. In this case, one of more an NP structure, an NPNP structure and an N(PNP) which are reversed forms of the PN structure 20 of FIG. 2A, the PNPN structure 30 of FIG. 3A or the P(NPN) structure 40 of FIG. 4A may be included in the 3DSFET devices, according to embodiments. In these embodiments, an upper source/drain contact plug may be connected to Vdd, and a lower source/drain contact plug may be included a BSPDN network and connected to Vss.

Further, in the above embodiment, each of the channel structures based on which the lower source/drain region (Epi) and the upper source/drain region (Epis) are grown may be formed of a plurality of nanosheet channel layers vertically stacked to form a nanosheet transistor, or one or more vertical fin structures horizontally arranged to form a FinFET. The channel structures may be surrounded by the gate structure in a channel-width cross-section view. Thus, each of the PMOS and the NMOS forming a corresponding 3DSFET device may be either a nanosheet transistor or a FinFET, or one of the lower field-effect transistor and the upper field-effect transistor may be a FinFET while the other may be a nanosheet transistor, according to embodiments.

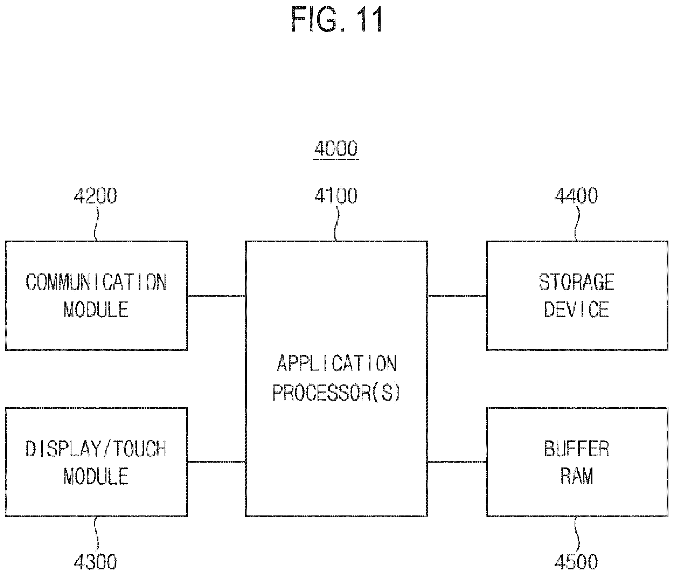

FIG. 11 is a schematic block diagram illustrating an electronic device including at least one 3DSFET device including one or more of a PN structure, a PNPN structure and a P(NPN) structure for a lower source/drain region and an upper source/drain region, according to an embodiment.

Referring to FIG. 11, an electronic device 4000 may include at least one application processor 4100, a communication module 4200, a display/touch module 4300, a storage device 4400, and a buffer RAM 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

At least one component in the electronic device 4000 may include at least one of the PN structure 20, the PNPN structure 30 and the P(NPN) structure 40 shown in FIGS. 2A-2B to 4A-4B.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

## Claims

1. A three-dimensionally stacked field-effect transistor, 3DSFET, device comprising:
a 1^{st} lower source/drain region and a 2^{nd} lower source/drain region connected to each other through a 1^{st} lower channel structure controlled by a 1^{st} gate structure; and
a 1^{st} upper source/drain region and a 2^{nd} upper source/drain regions, respectively above the 1^{st} lower source/drain region and the 2^{nd} lower source/drain region, and connected to each other through a 1^{st} upper channel structure controlled by the 1^{st} gate structure,
wherein the 2^{nd} lower source/drain region and the 2^{nd} upper source/drain region form a PN junction therebetween.

2. The 3DSFET device of claim 1, wherein one of the 2^{nd} lower source/drain region and the 2^{nd} upper source/drain region is configured to output a 1^{st} signal from the 1^{st} lower source/drain region or the 1^{st} upper source/drain region.

3. The 3DSFET device of claim 2, further comprising a 1^{st} contact plug, on the 2^{nd} lower source/drain region or the 2^{nd} upper source/drain region, configured to output the 1^{st} signal,
wherein there is no other contact plug on the 2^{nd} lower source/drain region or the 2^{nd} upper source/drain region to output the 1^{st} signal or receive another signal.

4. The 3DSFET device of claim 3, wherein the 1^{st} contact plug is on a top of the 2^{nd} upper source/drain region or on a bottom surface of the 2^{nd} lower source/drain region.

5. The 3DSFET device of claim 4, wherein one of the 2^{nd} lower source/drain region and the 2^{nd} upper source/drain region is configured to output the 1^{st} signal through the other of the 2^{nd} lower source/drain region and the 2^{nd} upper source/drain region.

6. The 3DSFET device of claim 4, wherein when one of the 2^{nd} lower source/drain region and the 2^{nd} upper source/drain region outputs the 1^{st} signal, the other of the 2^{nd} upper source/drain region and the 2^{nd} upper source/drain region is configured to float.

7. The 3DSFET device of claim 1 or 2, further comprising:
a PN junction structure in a reverse-biased form between the 1^{st} lower source/drain region and the 1^{st} upper source/drain region; and
a 1^{st} contact plug, on the 2^{nd} lower source/drain region or the 2^{nd} upper source/drain region, configured to output a 1^{st} signal from the 1^{st} lower source/drain region or the 1^{st} upper source/drain region,
wherein there is no other contact plug on the 2^{nd} lower source/drain region or the 2^{nd} upper source/drain region to output the 1^{st} signal or receive another signal.

8. The 3DSFET device of claim 7, wherein the 1^{st} lower source/drain region and the 1^{st} upper source/drain region are connected to opposite-polarity voltage sources, respectively, and
wherein the 1^{st} lower source/drain region is connected to one of the voltage sources through a backside contact plug on a bottom surface of the 1^{st} lower source/drain region.

9. The 3DSFET device of claim 7 or 8, further comprising:
a 3^{rd} lower source/drain region connected to the 1^{st} lower source/drain region through a 2^{nd} lower channel structure controlled by a 2^{nd} gate structure, the 3^{rd} lower source/drain region being at a side opposite to the 2^{nd} lower channel structure with respect to the 1^{st} lower source/drain region; and
a 3^{rd} upper source/drain region, above the 3^{rd} lower source/drain region, connected to the 1^{st} upper source/drain region through a 2^{nd} upper channel structure controlled by the 2^{nd} gate structure,
wherein the 3^{rd} lower source/drain region and the 3^{rd} upper source/drain region form a PN junction therebetween.

10. The 3DSFET device of claim 9, wherein one of the 3^{rd} lower source/drain region and the 3^{rd} upper source/drain region is configured to output a 2^{nd} signal from the 1^{st} lower source/drain region or the 1^{st} upper source/drain region.

11. The 3DSFET device of claim 10, wherein one of the 3^{rd} lower source/drain region and the 3^{rd} upper source/drain region is configured to output the 2^{nd} signal to the 1^{st} gate structure.

12. The 3DSFET device of any one of claims 3 to 8, further comprising:
a 3^{rd} lower source/drain region connected to the 1^{st} lower source/drain region through a 2^{nd} lower channel structure controlled by a 2^{nd} gate structure, the 3^{rd} lower source/drain region being at a side opposite to the 2^{nd} lower channel structure with respect to the 1^{st} lower source/drain region;
a 3^{rd} upper source/drain region, above the 3^{rd} lower source/drain region, connected to the 1^{st} upper source/drain region through a 2^{nd} upper channel structure controlled by the 2^{nd} gate structure;
a 1^{st} PN junction structure in a reverse-biased form between the 1^{st} lower source/drain region and the 1^{st} upper source/drain region; and
a 2^{nd} PN junction structure in a reverse-biased form between the 3^{rd} lower source/drain region and the 3^{rd} upper source/drain region,
wherein no contact plug is on the 1^{st} lower source/drain region to receive or output a signal,
wherein the 1^{st} lower source/drain region is configured to pass the 1^{st} signal from the 3^{rd} lower source/drain region to the 2^{nd} lower source/drain region.
